# EUROPÄISCHE PATENTSCHRIFT

(11) **EP 2 812 969 B1**
(45) Veröffentlichungstag und Bekanntmachung des Hinweises auf die Patenterteilung: **26.02.2020**
(21) Anmeldenummer: 13700378.6
(22) Anmeldetag: 14.01.2013
(51) Int. Cl.: H02J 1/10, G01R 31/40

(54) **STROMVERSORGUNG MIT PARALLELSCHALTBAREN AUSGÄNGEN**
DC/DC POWER SUPPLY WITH OUTPUTS THAT CAN BE CONNECTED IN PARALLEL
ALIMENTATION EN COURANT C.C./C.C. DOTÉE DE SORTIES COMMUTABLES EN PARALLÈLE

(30) Priorität: 06.02.2012 EP 12153967
(43) Veröffentlichungstag der Anmeldung: 17.12.2014
(73) Patentinhaber: Siemens Aktiengesellschaft, 80333 München (DE)
(72) Erfinder: AUGESKY, Christian, A-1100 Wien (AT); SCHWEIGERT, Harald, A-1120 Wien (AT)
(86) Internationale Anmeldenummer: PCT/EP2013/050562
(87) Internationale Veröffentlichungsnummer: WO 2013/117384

(56) Entgegenhaltungen:
- EP-A1- 0 158 007
- DE-A1- 19 704 662
- JP-A- 2009 232 545
- US-A1- 2006 119 992
- US-A1- 2011 018 580

## Beschreibung

Die Erfindung betrifft eine Stromversorgung mit wenigstens einer ersten und einer zweiten Wandlereinheit, wobei die erste Wandlereinheit mit einer ersten Steuerung angesteuert ist und an einem ersten Ausgang eine mittels einem ersten Spannungsregler geregelte erste Ausgangsspannung und/oder einen mittels eines ersten Stromreglers geregelten Ausgangsstrom liefert, wobei die zweite Wandlereinheit mit einer zweiten Steuerung angesteuert ist und an einem zweiten Ausgang eine mittels einem zweiten Spannungsregler regelbare zweite Ausgangsspannung und/oder einen mittels eines zweiten Stromreglers regelbaren Ausgangsstrom liefert und wobei die beiden Ausgänge zur Bereitstellung einer höhere Ausgangsleistung parallelschaltbar sind, wobei bei erkannter Parallelschaltung beide Spannungsregler und/oder Stromregler durch Vorgabe aufeinander abgestimmter Spannungssollwerte bzw. Stromsollwerte gekoppelt sind. Zudem betrifft die Erfindung ein Verfahren zum Betreiben einer solchen Stromversorgung.

Zweck einer Stromversorgung mit mehreren Wandlereinheiten ist zunächst die Versorgung mehrerer Lastzweige. Dazu sind zumindest zwei Wandlereinheiten mit einer jeweils geregelten Ausgangsspannung vorgesehen. In manchen Anwendungsfällen ist es notwendig, eine Last zu versorgen, deren Leistung die Ausgangsleistung einer Wandlereinheit übersteigt.

Um eine höhere Ausgangsleistung zur Verfügung zu stellen, werden deshalb zwei oder mehrere Ausgänge parallel geschaltet. Zur Versorgung einer Last steht dann die Summe der Leistungen der parallel geschalteten Ausgänge bereit. Um zu vermeiden, dass in einem solchen Parallelbetrieb eine Wandlereinheit verstärkt belastet wird, kennt man verschiedene Maßnahmen.

Bei getakteten Stromversorgungen ist es üblich, ein sogenanntes hartes Parallelschalten vorzusehen. Dabei werden die internen Regelkreise jeder Wandlereinheit vor der Parallelverschaltung auf einen gewünschten Ausgangsspannungswert und gegebenenfalls auf einen gewünschten Strombegrenzungswert eingestellt. Im Betrieb weisen die Spannungsregler aufgrund einer begrenzten Einstellgenauigkeit und einer natürlichen Drift geringe Differenzen der Sollspannungswerte auf. Deshalb versorgt bei steigendem Laststrom die Wandlereinheit mit der höchsten Ausgangsspannung die gesamte Last, bis die entsprechend Stromgrenze erreicht ist. Infolgedessen bricht die Ausgangsspannung dieser Wandlereinheit ein und weitere parallel geschaltete Wandlereinheiten mit zuvor geringerem Sollspannungswert liefern Strom in den gemeinsamen Ausgang.

Nachteilig ist dabei der umständliche Abgleichprozess, welcher von einem Bedienpersonal durchzuführen ist. Zudem erfolgt bei Teillast keine Aufteilung der Belastung auf alle parallel geschaltete Wandlereinheiten. Dadurch kommt es zu einem stärkeren Verschleiß jener Wandlereinheit, welche die überwiegende Leistung liefert. Das führt zu einer ungleichen Alterung und birgt das Risiko einer frühzeitigen Anlagenstörung.

Ein solches hartes Parallelschalten eignet sich nicht für Wandlereinheiten, welche nach einer gewissen Zeit im Strombegrenzungsbetrieb gänzlich abschalten. Nach einem Abschaltvorgang könnten die restlichen Wandlereinheiten nicht mehr die geforderte Leistung liefern und würden ebenfalls abschalten.

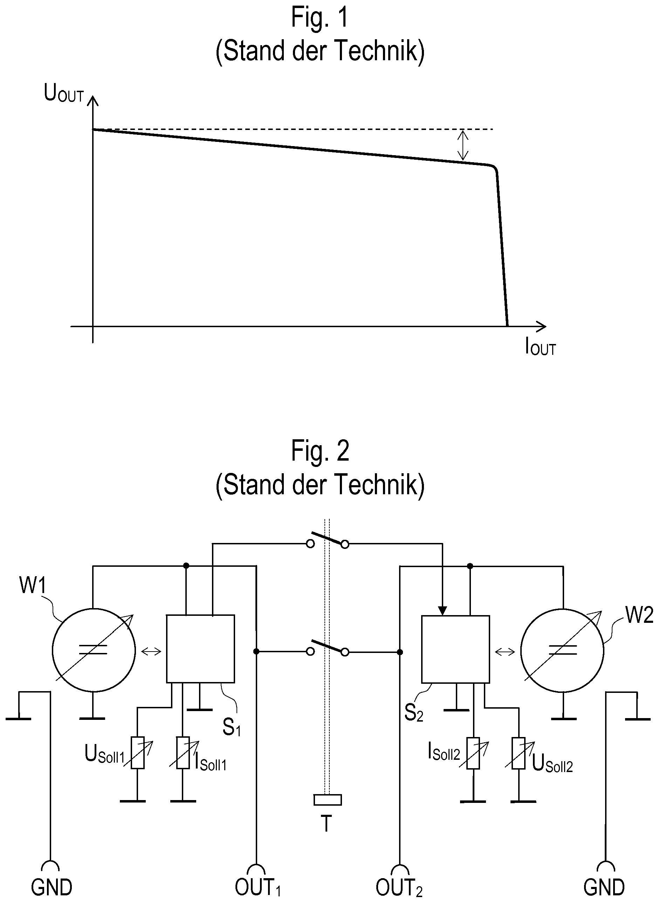

Eine andere bekannte Maßnahme sieht eine besondere Charakteristik der Ausgangsspannungsregler vor. Dabei wird mit steigendem Strom die Ausgangsspannung abgesenkt. Man spricht in diesem Zusammenhang von einer weichen Kennlinie (Fig. 1) der entsprechenden Wandlereinheit. Die Absenkung wird so gewählt, dass einerseits die von einer angeschlossenen Last vorgegebenen Toleranzen der Ausgangsspannung nicht überschritten werden. Andererseits muss die Absenkung ausreichend hoch sein, um ein Mehrfaches der Einstellgenauigkeit, der Drift im Betrieb, der Alterungsdrift und den Spannungsabfällen der Verschaltungskabel bis zur gemeinsamen Last zu betragen. Der oben beschriebene Effekt beim harten Parallelschalten hat dann nur mehr einen untergeordneten Einfluss.

Weiterhin nachteilig ist das aufwändige Justieren durch ein Bedienpersonal, insbesondere bei Ausgangsspannungen, die nicht den ursprünglichen Werkseinstellungen entsprechen. Zunächst muss eine Verbindung der Ausgänge getrennt werden. Die Ausgangsspannungen der einzelnen Spannungsregler müssen sodann auf den neuen gewünschten Wert mit einer vorgegebenen maximalen Abweichung zueinander eingestellt werden, bevor die Ausgänge wieder verbunden werden könnten. Wird statt einer Verkabelung mit einem gemeinsamen Verschaltpunkt eine durchschleifende Verkabelung (Daisy-Chain-Verdrahtung) der Ausgänge vorgenommen, tritt der Nachteil auf, dass die Spannungsabfälle an den Kabeln nichts zur Symmetrierung beitragen. Vielmehr tritt der gegenteilige Effekt auf, da die erste Wandlereinheit einen größeren Kabelwiderstand bis zur Last aufweist als die letzte Wandlereinheit. Dieser Kabelwiderstand führt auch bei sehr eng tolerierten Ausgangsspannungen der einzelnen Wandlereinheiten zu einem deutlichen Unterschied in der Stromabgabe.

Stromversorgungen, die in elektrotechnischen Labors zum Einsatz kommen, verfügen in der Regel über mehrere geregelte Ausgänge. Dabei können zwei Ausgänge parallel geschaltet werden. Das geschieht mittels eines Schalters, welcher sowohl die Leistungsausgänge als auch die Signalisierungspfade der internen Steuerungen zusammenschaltet. Der Schalter weist dabei mehrere Kontakte auf und verbindet die Ansteuerungen der Ausgänge in der Art, dass ein zuvor festgelegter Spannungs- und Stromregler für beide Ausgänge gilt (Fig. 2). Eine solche Lösung ist für Stromversorgungen im Industriebereich nur bedingt einsetzbar. Zum einen könnte das Bedienpersonal gewollt oder versehentlich die Ausgänge mittels einer Verbindungsleitung parallel schalten, ohne den Schalter zu betätigen. Dann funktioniert die Symmetrierung der Ausgänge nicht. Zum anderen können bei mehr als zwei Ausgängen nur die beiden Ausgänge parallel geschaltet werden, die einen entsprechenden Schalter aufweisen. Zudem würde ein solcher Schalter in Industriegeräten hohe Gleichströme und mehrere Signale schalten können, weshalb nur teure Sonderanfertigungen in Frage kommen.

Aus der DE 197 04 662 A1 ist eine Parallelschaltung mehrerer Stromversorgungen bekannt, wobei nach jedem Einschaltvorgang ein Master-Stromversorgungsmodul ermittelt wird. Dieses übernimmt dann im regulären Betrieb die Steuerung der Lastsymmetrierung.

Die US 2011/018580 A1 offenbart ein Computernetzteil mit mehreren permanent parallelgeschalteten Ausgangsstufen. Mittels einer Detektorschaltung sollen fehlerhafte Ausgangsstufen erkannt werden. Dabei werden die einzelnen Ausgangsstufen sequenziell angesteuert und mittels Detektorschaltung wird festgestellt, ob die jeweilige Ausgangsstufe auf die Ansteuerung reagiert.

Auch die JP 2009 232545 A betrifft eine Detektorschaltung zur Fehlererkennung eines Wandlers innerhalb einer permanenten Parallelschaltung.

Unterschiedlich ausgebildete oder angeordnete Kontaktstücke zur Parallelschaltung zweier Stromversorgungen sind aus der EP 0 158 007 A1 bekannt.

Die US 2006/119992 A1 offenbart eine Stromversorgung mit mehreren parallelschaltbaren Treiberstufen. Jeweils parallelgeschaltete Treiberstufen sind mittels einer gemeinsamen Ansteuerung ausgangsseitig an eine gemeinsame Induktivität geschaltet.

Der Erfindung liegt die Aufgabe zugrunde, für eine Stromversorgung der eingangs genannten Art eine Verbesserung gegenüber dem Stand der Technik anzugeben. Zudem soll ein Verfahren zum Betreiben der Stromversorgung angegeben werden. Erfindungsgemäß wird diese Aufgabe gelöst durch eine Stromversorgung gemäß unabhängigem Anspruch 1 und ein Verfahren gemäß unabhängigem Anspruch 12. Die abhängigen Ansprüche beschreiben verschiedene Weiterbildungen der erfindungsgemäßen Lösung.

Dabei ist vorgesehen, dass eine übergeordnete Steuerung eine Überwachungseinheit zum Erkennen einer ausgangsseitigen Parallelschaltung umfasst, dass der Überwachungseinheit ein Erkennungssignal zugeführt ist, welches bei parallel geschalteten Ausgängen automatisch seinen Signalzustand ändert und dass die übergeordnete Steuerung mit den Steuerungen der beiden Wandlereinheiten zur Änderung der Sollwerte verbunden ist. Sobald eine ausgangsseitige Parallelschaltung erfolgt, schalten die Stromversorgung selbsttätig in einen Symmetrierungsmodus, ohne ein weiteres Zutun des Bedienpersonals. Es sind keine Justierarbeiten oder sonstigen Vorkehrungen erforderlich. Dieser Vorteil kommt insbesondere dann zum Tragen, wenn eine zu versorgende Last eine andere Ausgangsspannung als die ursprüngliche Werkseinstellung der Stromversorgung benötigt. Das Bedienpersonal muss dann nur einen Spannungssollwert einstellen und der Spannungssollwert für den zweiten Ausgang ändert sich automatisch, sobald eine Parallelschaltung vorliegt. Auch bei bereits parallel geschalteten Ausgängen kann durch Einstellen der Ausgangsspannung einer als führend definierten Wandlereinheit die Spannung aller parallel geschalteter Ausgänge mit verändert werden, wobei die Lastaufteilung der Leistungsteile stets erhalten bleibt. Dabei ist unabhängig von der Art einer mechanischen Verbindung beider Ausgänge gewährleistet, dass eine Parallelschaltung der Ausgänge sicher erkannt wird

Vorteilhafterweise sind die Spannungssollwerte als ein gemeinsamer Spannungssollwert vorgegeben. Den Spannungsreglern der beiden Wandlereinheiten wird derselbe Sollwert vorgegeben, sodass eine vollständige Symmetrierung gegeben ist.

In gleicher Weise ist es vorteilhaft, wenn die Stromsollwerte als ein gemeinsamer Stromsollwert vorgegeben sind. Beispielsweise werden die Stromsollwerte dabei durch eine Schalttransistor-Einschaltzeit einer als Schaltwandler ausgebildeten Wandlereinheit abgeleitet, ohne einen eigenen Stromregler vorzusehen.

In einer Weiterbildung ist vorgesehen, dass jede Steuerung einen Stromregler zur Regelung eines über den zugeordneten Ausgang fließenden Stromes umfasst. Jede Wandlereinheit ist dann bis zu einem maximalen Strom belastbar und begrenzt im Überlastfall den Strom auf diesen Wert.

Dabei ist es von Vorteil, wenn jeder Stromregler den gekoppelten Spannungsreglern unterlagert ist. Die Spannungsregler geben aufeinander abgestimmte Sollspannungen vor und die Stromregler regeln die Ströme. Konkret gibt der jeweilige Spannungsregler eines Ausgangs als Regelabweichung einen Sollwert für den dazugehörenden Stromregler vor. Am jeweiligen Ausgang ist dann eine Stromquelle realisiert, deren Ausgangsstrom bewirkt, dass der dem Spannungsregler vorgegebene Spannungssollwert erreicht wird.

In einer anderen Ausprägung ist vorgesehen, dass eine Steuerung als Master eingerichtet ist und dass bei Erkennen einer Parallelschaltung die andere Steuerung als Slave die Spannungs- und/oder Stromsollwerte des Masters übernimmt. Dabei umfasst günstigerweise die als Slave vorgesehene Steuerung die Überwachungseinheit zum Erkennen einer ausgangsseitigen Parallelschaltung. Sobald eine solche Parallelschaltung erkannt wird, übernimmt die Slavesteuerung die Sollwerte für die Ausgangsspannung und/oder den Ausgangsstrom und gegebenenfalls für einen maximalen Begrenzungsstrom von der Mastersteuerung.

Alternativ dazu ist vorgesehen, dass eine Steuerung als Master eingerichtet ist und dass bei Erkennen einer Parallelschaltung die andere Steuerung als Slave Ein- und/oder Ausschaltzeiten oder Ein- und/oder Ausschaltzeitpunkte des Masters übernimmt. Die beiden als Schaltwandler ausgebildeten Wandlereinheiten werden dann mit denselben Schaltsteuersignalen betrieben. Damit wird ein Steuerungsprogramm in einer DSP-Steuerung deutlich vereinfacht.

Zur Bildung eines Erkennungssignals ist es von Vorteil, wenn die beiden Ausgänge mittels eines Verbindungsstücks verbunden sind und wenn das Verbindungsstück mechanisch an einen elektrischen Hilfskontakts zur Beeinflussung des Erkennungssignals gekoppelt ist. Ein an dem Hilfskontakt anliegendes Signal ändert somit automatisch seinen Signalzustand, sobald das Verbindungsstück angebracht oder entfernt wird.

Dabei ist günstigerweise vorgesehen, dass bei mehr als zwei Ausgängen die Abmessungen des Verbindungsstücks und der Ausgänge in der Weise vorgegeben sind, dass nur bestimmte Ausgänge mittels Verbindungsstück verbindbar sind. Durch diese Maßnahme ist sichergestellt, dass nur solche Ausgänge miteinander verbunden werden, die mittels Überwachungseinheit überprüfbar sind. Zudem lässt sich im Vorhinein festlegen, welche Steuerung als Master und welche Steuerung als Slave konfiguriert ist.

Eine einfache Ausführung sieht vor, dass bei nicht verbundenen Ausgängen der elektrische Hilfskontakt offen oder geschlossen ist und dass bei verbundenen Ausgängen mittels Verbindungsstück dieser elektrische Hilfskontakt entgegen dem vorherigen Zustand geschlossen oder geöffnet ist. Sobald ein Verbindungsstück die beiden Ausgänge verbindet, wird zwangsläufig der elektrische Hilfskontakt beeinflusst. Ein zuvor geöffneter Hilfskontakt wird geschlossen bzw. ein zuvor geschlossener Hilfskontakt wird geöffnet.

In einer anderen Variante ist vorgesehen, dass bei verbundenen Ausgängen mittels Verbindungsstück ein elektromechanisches Betätigungselement betätigt ist. Ein solches Betätigungselement ist beispielsweise ein Druckknopf oder ein Schalter, welcher in einfacher Weise neben einem Ausgang platzierbar ist. Konkret ist dieses Betätigungselement so platziert, dass es beim Anbringen und beim Entfernen der Leistungsverbindung von zwei oder mehreren Ausgängen zumindest einmal betätigt wird oder während der gesamten Zeit des Bestehens der Leistungsverbindung betätigt wird. Damit ist auch ein Druckschalter verwendbar, der beim Einsetzen eines Verbindungsstücks mittels einer Ausbuchtung einmal betätigt wird und eingeschaltet. Erst beim Entfernen des Verbindungsstücks wird der Druckschalter durch nochmalige Betätigung ausgeschaltet.

Eine weitere Variante zur Beeinflussung eines Hilfskontakts ist gegeben, wenn bei verbundenen Ausgängen mittels Verbindungsstück ein mechanischer oder elektromagnetischer Sensor aktiviert ist.

Ein erfindungsgemäßes Verfahren zum Betreiben einer Stromversorgung weist zumindest eine erste und eine zweite Wandlereinheit auf, wobei die erste Wandlereinheit mittels einer ersten Steuerung angesteuert wird zur Ausgabe einer mittels eines ersten Spannungsreglers geregelten Ausgangsspannung und/der eines mittels eines ersten Stromreglers geregelten ersten Ausgangsstromes an einem ersten Ausgang, wobei die zweite Wandlereinheit mittels einer zweiten Steuerung angesteuert wird zur Ausgabe einer mittels eines zweiten Spannungsreglers geregelten zweiten Ausgangsspannung und/der eines mittels eines zweiten Stromreglers geregelten zweiten Ausgangsstromes an einem zweiten Ausgang und wobei die beiden Ausgänge zur Bereitstellung einer höhere Ausgangsleistung parallel geschaltet werden, wobei bei erkannter Parallelschaltung beiden Spannungsreglern und/oder Stromreglern aufeinander abgestimmte Spannungssollwerte bzw. Stromsollwerte vorgegeben werden. Dabei umfasst eine übergeordnete Steuerung, welche mit den Steuerungen der beiden Wandlereinheiten zur Änderung der Sollwerte verbunden ist, eine Überwachungseinheit zum Erkennen einer ausgangsseitigen Parallelschaltung, wobei der Überwachungseinheit ein Erkennungssignal zugeführt wird, welches bei parallel geschalteten Ausgängen automatisch seinen Signalzustand ändert. In einer einfachen Variante werden im Parallelbetrieb nur Stromsollwerte aufeinander abgestimmt und der Spannungsregler einer Wandlereinheit ist deaktiviert. Ein weiter vereinfachtes Betreiben der Wandlereinheiten sieht vor, dass nur die Schaltzeitpunkte oder Ein-/ bzw. Ausschaltzeitdauern der einen Wandlereinheit der anderen

Wandlereinheit vorgegeben wird. Die Sollwerte sind auf diese Weise besonders einfach aufeinander abgestimmt, weil beide Wandlereinheiten zwangsläufig mit der gleichen Leistung betrieben werden. Eine solche Methode ist besonders bei einer Betriebsart anwendbar, die Strom-Betrieb oder Discontinous-Betrieb genannt wird. Dabei wird eine Drossel der jeweiligen Wandlereinheit immer komplett entladen, wodurch beim Wiedereinschalten der Strom und damit die Energie in der Drossel nur von einer Eingangsspannung und der Induktivität abhängig ist.

Ein einfaches Verfahren sieht vor, dass bei einer Verbindung der beiden Ausgänge mittels eines Verbindungsstücks zusätzlich mittels Verbindungsstück ein Hilfskontakt geöffnet oder geschlossen wird.

Zur Erkennung einer Parallelschaltung ohne Verbindungsstück ist vorgesehen, dass bei einem Hochlaufvorgang der Stromversorgung eine Parallelschaltung der Ausgänge geprüft wird, indem zuerst die erste Wandlereinheit hochgefahren wird und dass dabei am Ausgang der zweiten Wandlereinheit die Ausgangsspannung als Erkennungssignal erfasst wird. Wenn die Ausgangsspannung der zweiten Wandlereinheit bereits mit der Ausgangsspannung der ersten Wandlereinheit steigt, wird eine Parallelschaltung erkannt. In einer verbesserten Variante können die beiden Ausgangsspannungen für eine vorgegebene Zeitspanne oder in Abhängigkeit einer erreichten Spannungshöhe Abweichungen aufweisen, die nicht höher sind als ein vorgegebener Toleranzbereich. Dieser Toleranzbereich berücksichtigt zumindest die Messgenauigkeit der Spannungserfassung an den Ausgängen und die zu erwartenden Spannungsabfälle durch die in einer Betriebsanleitung vorgegebenen möglichen Leistungsverbindungen.

Dieses Verfahren ist auch für mehr als zwei Ausgänge einfach realisierbar, indem eine vorgegebene Abfolge des Hochlaufens der einzelnen Ausgänge befolgt wird. Die Spannungen an den noch nicht hochgefahren Ausgängen werden dahingehend überwacht, ob sie mit der aktuell hochfahrenden Spannung mitgehen. Mit diesem Verfahren sind beliebige Verschaltungen erkennbar, auch solche mit längeren Kabeln oder hochohmigen Kabeln.

Um auch während eines Betriebs eine Parallelschaltung zu erkennen, ist es von Vorteil, wenn jede Wandlereinheit mittels eines Stromreglers angesteuert wird, wenn im laufenden Betrieb einem Stromregler ein kurzzeitig veränderter Stromsollwert vorgegeben wird und wenn währenddessen die Differenz der beiden Ausgangsspannungen als Erkennungssignal erfasst wird. Wenn trotz Vorgabe eines veränderten Stromsollwerts die Differenz der beiden Ausgangsspannungen unterhalb eines Schwellenwertes bleibt, wird eine Parallelschaltung der Ausgänge erkannt.

Alternativ dazu ist auch vorgesehen, dass bei einer Ansteuerung jeder Wandlereinheit mittels eines Stromreglers im laufenden Betrieb eine Wandlereinheit mit kurzzeitig verändertem Stromsollwert angesteuert wird und dass währenddessen ein Stromistwert der anderen Wandlereinheit als Erkennungssignal erfasst wird. Ein veränderter Stromistwert der anderen Wandlereinheit zeigt dabei eine Parallelschaltung der Ausgänge an.

Eine weitere Variante zur Erkennung einer Parallelschaltung ist gegeben, wenn zwischen den beiden Ausgängen mittels einer zusätzlichen Spannungsquelle Strom eingeprägt wird und wenn dabei die Differenz der beiden Ausgangsspannungen als Erkennungssignal erfasst wird. Wenn die Ausgangsspannungsdifferenz unterhalb eines vorgegebenen Schwellenwertes bleibt, liegt eine Parallelschaltung vor.

In einer anderen Variante ist vorgesehen, dass jeder Wandlereinheit mittels eines Stromreglers angesteuert wird, dass einer Wandlereinheit kurzzeitig ein Stromsollwert direkt vorgegeben wird, sodass die entsprechende Wandlereinheit im reinen Stromquellbetrieb läuft und dass die Spannung am Ausgang dieser Wandlereinheit als Erkennungssignal erfasst wird. Dieses Verfahren wird durchgeführt, wenn eine Parallelschaltung angenommen wird und eine Steuerung als Slave die Spannungsregelung des Masters übernimmt. Die Steuerung mit kurzzeitig direkt vorgegebenem Stromsollwert arbeitet dabei als Slave. Eine Parallelschaltung liegt vor, wenn die Ausgangsspannung am Ausgang dieser Wandlereinheit weiterhin auf den Wert regelt, den der Spannungsregler der Mastersteuerung vorgibt. Entsteht hingegen eine Spannungsdifferenz zwischen den Ausgängen, liegt keine Parallelschaltung vor und der Slave schaltet sofort auf die Spannungsregelung mit eigenem Sollspannungswert zurück. Bei der Entscheidung, ob eine Spannungsdifferenz zwischen den Ausgängen vorliegt, wird günstigerweise eine Toleranz berücksichtigt. Nur wenn diese Toleranz überschritten wird, erfolgt eine Rückschaltung in den ursprünglichen Zustand mit entkoppelten Regelungen.

Günstigerweise entspricht der direkt vorgegebene Stromsollwert dem Stromsollwert der anderen Wandlereinheit. Damit ist eine einfache Überprüfung möglich, sobald eine der oben beschriebenen Methoden zu dem Ergebnis kommt, dass eine Parallelschaltung vorliegt. Der Stromregler-Sollwert einer Mastersteuerung wird kurzzeitig auf die Slavesteuerung übertragen. Damit sind keine umständlichen Regelschleifen zu berücksichtigen, welche eine Schwingneigung hervorrufen können. Laufen die Ausgangsspannungen der beiden Wandlereinheiten in diesem Überprüfungsmodus auseinander, so besteht keine Parallelschaltung. Bleiben die Ausgangsspannungen auf demselben Niveau, so ist die Annahme einer Parallelschaltung bestätigt.

Von Vorteil ist es, wenn die Differenz der beiden Ausgangsspannungen laufend erfasst wird und wenn bei einem Abfall dieser Differenz unter einer Mindestwert ein Erkennungsvorgang für eine mögliche Parallelschaltung der beiden Ausgänge eingeleitet wird. Somit ist sichergestellt, dass eine Parallelschaltung während eines Betriebs der Stromversorgung sofort erkannt wird. Alternativ dazu wird in vorgegebenen Zeitabständen eine Überprüfung durchgeführt, ob eine Parallelschaltung vorliegt.

Zudem ist es vorteilhaft, wenn bei beiden Wandlereinheiten eine interne Ausgangsspannung erfasst wird, dass bei erkannter Parallelschaltung die Differenz dieser internen Ausgangsspannungen mit einem vorgegebenen Maximalwert verglichen wird und dass bei Überschreitung des Maximalwertes eine Abschaltung der Stromversorgung oder eine Aktivierung eines Meldesignals erfolgt. Mit diesem Verfahren wird geprüft, ob eine Verbindung zwischen den Ausgängen niederohmig oder hochohmig ausgebildet ist. Eine zu hochohmige Verbindung könnte zu einer unzulässigen Erhitzung führen, weshalb eine Abschaltung erfolgen sollte. Bei einer Versorgung von Anlagenteilen mit hoher Verfügbarkeitsanforderung kann es sinnvoll sein, auch in diesem Fall die Stromversorgung weiter zu betreiben und ein Bedienpersonal mittels Meldesignal zu alarmieren.

Die Erfindung wird nachfolgend in beispielhafter Weise unter Bezugnahme auf die beigefügten Figuren erläutert. Es zeigen in schematischer Darstellung:
- Fig. 1: Weiche Kennlinie einer Wandlereinheit
- Fig. 2: Zwei Wandlereinheiten mit Parallelschaltmöglichkeit mittels Taster
- Fig. 3: Zwei Wandlereinheiten mit Parallelschaltmöglichkeit mittels Verbindungsstück
- Fig. 4: Signalverarbeitung in einer als Slave ausgebildeten Steuerung
- Fig. 5: Spannungs- und Stromverläufe bei einer Erkennung einer Parallelschaltung während eines Hochlaufvorgangs
- Fig. 6: Zwei Wandlereinheiten mit automatischer Parallelschaltungserkennung mittels übergeordneter Steuerung
- Fig. 7: Spannungs- und Stromverläufe mit kurzzeitig geändertem Stromsollwert einer Wandlereinheit und parallel geschalteten Ausgängen
- Fig. 8: Spannungs- und Stromverläufe mit kurzzeitig geändertem Stromsollwert einer Wandlereinheit ohne parallel geschalteten Ausgängen
- Fig. 9: Drei Wandlereinheiten mit Parallelschaltungserkennung
- Fig. 10: Anordnung zur Parallelschaltungserkennung im Betrieb durch Einprägen eines Stromes
- Fig. 11: Vereinfachte Anordnung zur Parallelschaltungserkennung im Betrieb durch Einprägen eines Stromes
- Fig. 12: Mechanische Verbindung zweier Ausgänge mittels Verbindungsstück
- Fig. 13: Anordnung dreier Ausgänge mit Hilfskontakten und zwei Verbindungsstücken
- Fig. 14: Mechanische Verbindung zweier Ausgänge mittels Verbindungsstück und einem Betätigungselement
- Fig. 15: Mechanische Verbindung zweier Ausgänge mittels Verbindungsstück und einem Hilfskontakt mit Signaleinheit
- Fig. 16: Mechanische Verbindung zweier Ausgänge mittels Verbindungsstück und einem Hilfskontakt

Nach dem Stand der Technik weisen Wandlereinheiten eine weiche Kennlinie auf, wenn eine Parallelschaltung von mehreren Wandlereinheiten erfolgen soll (Fig. 1). Dabei sinkt die Ausgangsspannung U_{OUT} bei steigendem Ausgangsstrom I_{OUT} merklich ab. Die Ausgangsspannungswerte der Wandlereinheiten mit parallel geschalteten Ausgängen werden auf einen gemeinsamen Wert justiert. Das bewusste Absinken der Ausgangsspannung U_{OUT} bei steigenden Strom I_{OUT} dient einem Ausgleich von Einstelltoleranzen, Kabelspannungsabfällen etc.

Eine bekannte Zusammenschaltung zweier Wandlereinheiten W1, W2 ist in Fig. 2 dargestellt. Jede Wandlereinheit W1 bzw. W2 liefert am dazugehörigen Ausgang OUT₁ bzw. OUT₂ eine einstellbare Ausgangsspannung gegenüber Masse GND. Angesteuert wird jede Wandlereinheit W1 bzw. W2 mittels einer eigenen Steuerung S₁ bzw. S₂, wobei jede Steuerung S₁ bzw. S₂ einen Spannungsregler und einen Stromregler umfasst. Jeder Steuerung S₁ bzw. S₂ sind zunächst ein eigener Spannungssollwert U_{Soll1} bzw. U_{Soll2} und ein eigener Stromsollwert I_{Soll1} bzw. I_{Soll2} vorgegeben.

Eine Parallelschaltung der beiden Ausgänge OUT₁ bzw. OUT₂ erfolgt mittels eines Tasters T. Dabei werden gleichzeitig die beiden Steuerungen S₁, S₂ in der Weise zusammengeschaltet, dass die eine Steuerung S₂ die Sollwerte U_{Soll1} bzw. I_{Soll1} der anderen Steuerung S₁ übernimmt. Die beiden Wandlereinheiten W1, W2 werden also durch Betätigung eines Tasters T in einen Parallelbetrieb umgeschaltet.

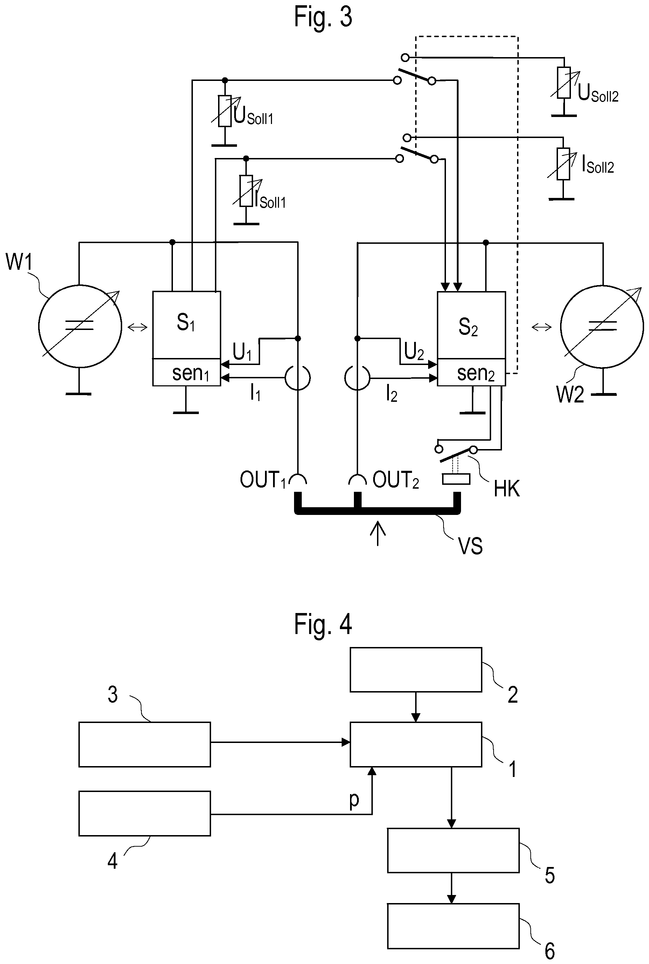

In einer Variante der vorliegenden Erfindung geschieht die Zusammenschaltung der beiden Wandereinheiten W1, W2 mittels eines Verbindungsstücks VS (Fig. 3). Jede Wandlereinheit W1, W2, weist eine Steuerung S₁ bzw. S₂ mit einer jeweiligen Sensoreinheit sen₁ bzw. sen₂ auf. Mittels der jeweiligen Sensoreinheit sen₁ bzw. sen₂ erfolgt eine laufende Erfassung der ausgangsseitigen Spannung U₁ bzw. U₂ und des Stromes I₁ bzw. I₂.

Jeder Steuerung S₁ bzw. S₂ sind für eine Spannungs- und eine Stromregelung jeweils ein eigener Spannungssollwert U_{Soll1} bzw. U_{Soll2} und ein eigener Stromsollwert I_{Soll1} bzw. I_{Soll2} vorgegeben. Im Beispiel gemäß Fig. 3 ist die erste Steuerung S₁ der ersten Wandlereinheit W1 als Master festgelegt und die zweite Steuerung S₂ der zweiten Wandlereinheit W2 fungiert als Slave.

Die beiden Ausgange OUT₁, OUT₂ der beiden Wandler W1, W2 sind mittels eines Verbindungsstück VS parallelschaltbar. Ein Anbringen des Verbindungsstücks VS aktiviert dabei einen Hilfskontakt HK, welcher mit der zweiten Steuerung S₂ verbunden ist. Auf diese Weise erhält die zweite Steuerung S₂ ein Erkennungssignal, ob eine Parallelschaltung vorliegt. Zur Auswertung des Erkennungssignals umfasst die zweite Steuerung S₂ eine Überwachungseinheit. Sobald die zweite Steuerung S₂ eine Parallelschaltung erkennt, erfolgt beispielsweise mittels elektronisch angesteuerten Schaltern eine Umschaltung von den eigenen Sollwerten U_{Soll2}, I_{Soll2} auf die Sollwerte U_{Soll1}, I_{Soll1} der Mastersteuerung S₁.

Die Signalabfolge dieses Vorgangs ist in Fig. 4 dargestellt. Einer Umschalteinrichtung 1, welche von der als Slave ausgebildeten Steuerung S₂ angesteuert bzw. umfasst ist, sind sowohl die eigenen Sollwerte U_{Soll2}, I_{Soll2} als auch die Sollwerte U_{Soll1}, I_{Soll1} der Mastersteuerung S₁ zugeführt. Mittels Überwachungseinheit 4 wird während eines Hochlaufvorgangs oder im laufenden Betrieb festgestellt, ob eine Parallelschaltung vorliegt. Dabei wird ein entsprechendes Ergebnissignal p der Umschalteinrichtung 1 zugeführt. Abhängig davon, ob eine Parallelschaltung erkannt wurde, erfolgt eine Vorgabe der entsprechenden Sollwerte U_{Soll1}, I_{Soll1} bzw. U_{Soll2}, I_{Soll2} an den Leistungsteil 5 der zum Slave S₂ gehörenden Wandlereinheit W2. Am Ausgang 6 liegt dann die gewünschte Ausgangsspannung U₂ an.

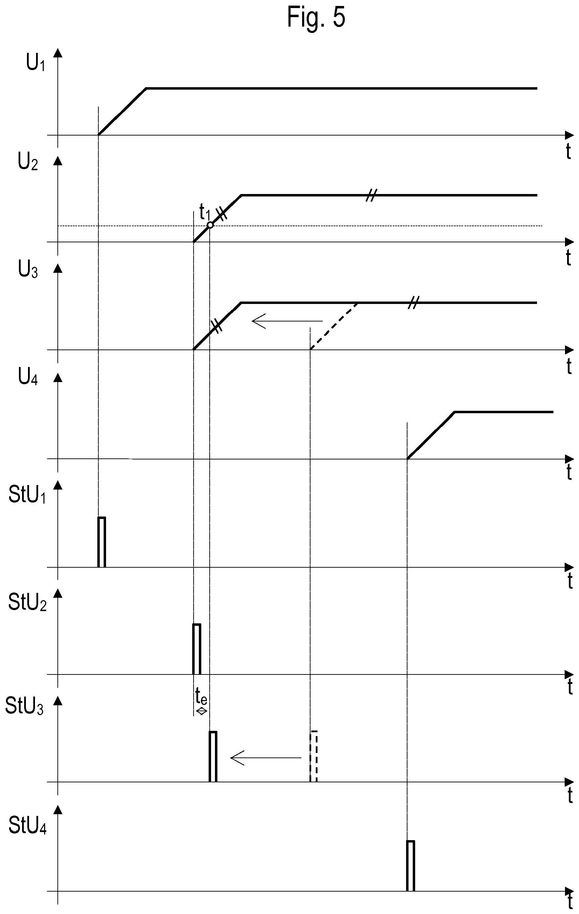

Zur Erkennung einer Parallelschaltung während eines Hochlaufs werden mehrere Wandlereinheiten nacheinander aktiviert. Die entsprechenden Spannungs- und Signalverläufe für vier Wandlereinheiten sind in Fig. 5 dargestellt. Die Startsignale StU₁, STU₂, StU₃, STU₄ zum Hochfahren der einzelnen Wandlereinheiten weisen zueinander einen zeitlichen Abstand auf. Während des Hochfahrens der ersten Wandlereinheit steigt die Ausgangspannung U₁ am ersten Ausgang mit einer Rampe bis zur vorgegeben Sollspannung an. In den anderen Wandlereinheiten wird währenddessen die Spannung am jeweiligen Ausgang überwacht. Wenn sich keine Spannungsänderungen ergeben, erfolgt das Hochlaufen der zweiten Wandlereinheit. Während die Spannung U₂ am Ausgang der zweiten Wandlereinheit ansteigt, wird nach einer Erkennungszeit tₑ zum Zeitpunkt t₁ erkannt, dass auch die Spannung U₃ am Ausgang der dritten Wandlereinheit ansteigt. Daraus wird in der Überwachungseinheit geschlossen, dass die Ausgänge der zweiten und dritten Wandlereinheit parallel geschaltet sind. Der Start der dritten Wandlereinheit wird daher gegenüber dem gestrichelt eingezeichneten, ursprünglich vorgesehen Zeitpunkt vorverlegt. Zuletzt wird die vierte Wandlereinheit hochgefahren.

Das Einschalten von Lasten mit sehr großen Kapazitäten kommt in einer ersten Einschaltphase einem Kurzschluss gleich. Deshalb ist es in solchen Fällen vorteilhaft, die Überprüfung des Gleichlaufes der Ausgangsspannungen auch dann fortzuführen, wenn beim Einschalten eines Ausganges ein Kurzschluss erkannt wird. Wird in Folge nach der vorgegebenen Wartezeit der nächste Ausgang aktiviert und das Ergebnis der Spannungsüberwachung zeigt ebenfalls einen Kurzschluss, so besteht die Möglichkeit dass beide Ausgänge an einem sehr großen Kondensator angeschlossen sind. Der Gleichlauf der Ausgangsspannungen kann somit erst bei erfolgtem Aufladen eines Lastkondensators bis zu einem vordefinierten Spannungswert eindeutig erkannt werden. Dieser vordefinierte Spannungswert liegt vorteilhafterweise deutlich oberhalb der Summe aller Auswertetoleranzen der einzelnen Ausgangsspannungen.

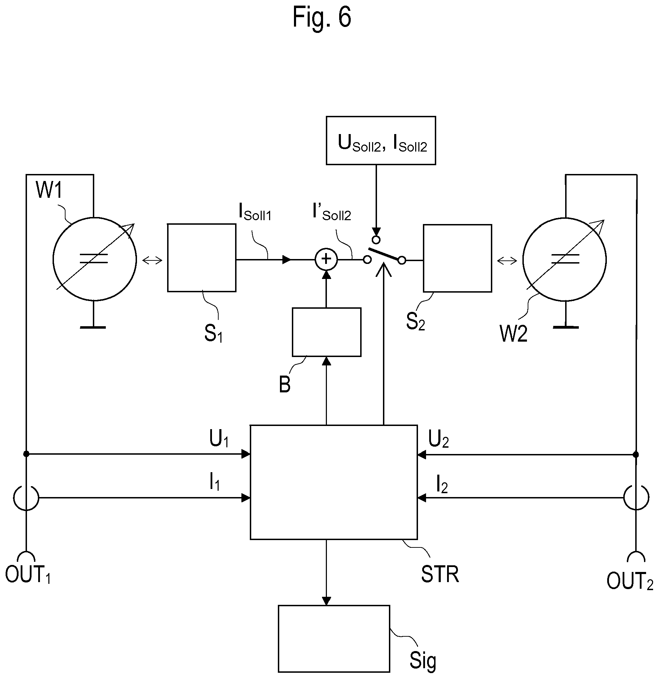

In Fig. 6 sind zwei zusammenschaltbare Wandlereinheiten W1, W2 mit einer übergeordneten Steuerung STR dargestellt. Der übergeordneten Steuerung STR sind die Istwerte der Spannungen U₁, U₂ und der Ströme I₁, I₂ an den Ausgängen OUT₁, OUT₂, der Wandlereinheiten W1, W2 zugeführt. Abhängig davon, ob eine Parallelschaltung vorliegt, werden der als Slave ausgebildeten zweiten Steuerung S₂ eigene Sollwerte U_{Soll2}, I_{Soll2} oder die Sollwerte U_{Soll1}, I_{Soll1} der Mastersteuerung S₁ zugeführt. Diese Umschaltung erfolgt mittels übergeordneter Steuerung STR, wobei die Sollwerte Uₛₒₗₗ₁, I_{Soll1} der Mastersteuerung S₁ mittels einer Sollwertbeeinflussung B modifizierbar sind. Beispielsweise kann damit der zweiten Steuerung S₂ kurzzeitig ein modifizierter Stromsollwert I'_{Soll2} zugeführt werden, um eine angenommene Parallelschaltung zu verifizieren.

Zusätzlich ist die übergeordnete Steuerung STR mit einer Signalisierungseinheit Sig zur Datenübertragung an eine Leittechnik verbunden.

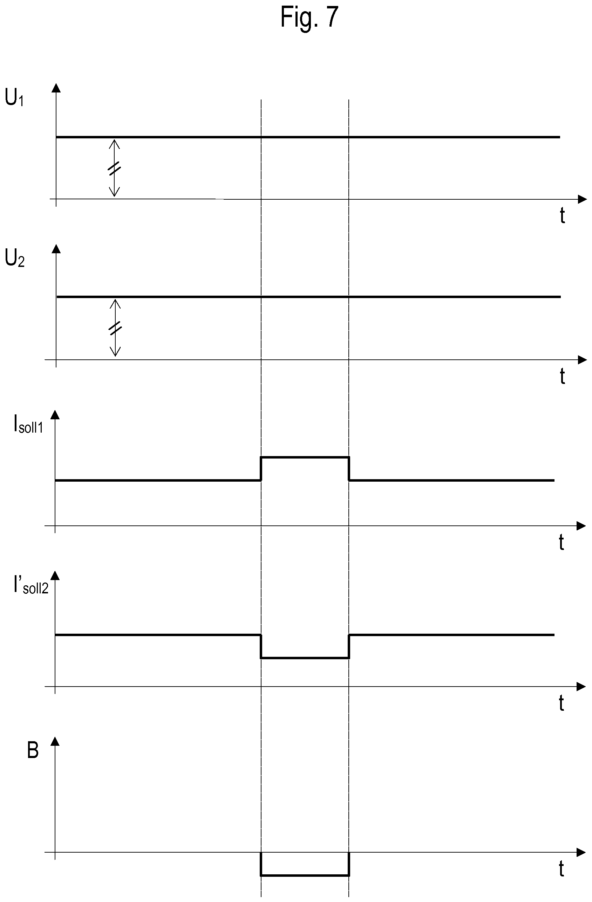

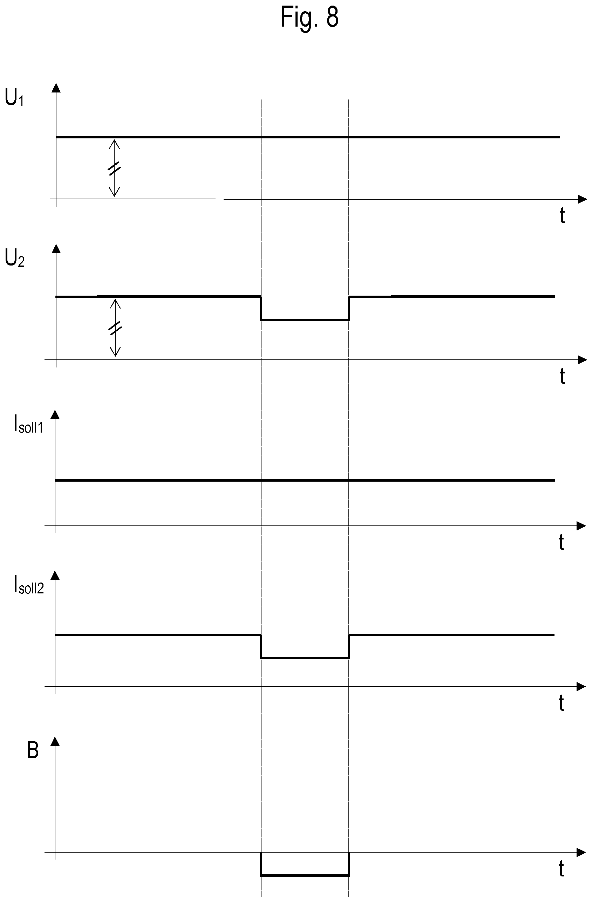

Signalverläufe zur Verifizierung einer Parallelschaltung durch kurzzeitige Änderung des Stromsollwerts I'_{Soll2} für die zweite Steuerung S₂ sind in den Fig. 7 und 8 dargestellt.

Fig. 7 zeigt die Verläufe bei parallel geschalteten Ausgängen. Mittels Sollwertbeeinflussung B wird der Stromsollwert I'_{Soll2} für die zweite Steuerung S₂ kurzzeitig reduziert. Die beiden Spannungen U₁, U₂ an den beiden Ausgängen bleiben gleich, wobei der ersten Wandlereinheit W1 als Folge einer geringfügig abfallenden Ausgangsspannung vom Spannungsregler der Steuerung S1 ein höherer Stromsollwert I_{Soll1} vorgegeben wird, um das Spannungsniveau zu halten. Die Auswertung der Reglerreaktion führt zur Schlussfolgerung, ob eine Parallelschaltung vorliegt oder nicht.

Anders verhält es sich, wenn keine Parallelschaltung vorliegt, wie in Fig. 8 dargestellt. Ein kurzzeitiges Absenken des Stromsollwertes I'_{Soll2} für die zweite Steuerung S₂ führt lediglich dazu, dass auch die Spannung U₂ am Ausgang der zweiten Wandlereinheit W2 sinkt. Die Spannung U₁ und der Sollstromwert I_{Soll1} der ersten Wandlereinheit W1 bleiben unbeeinflusst.

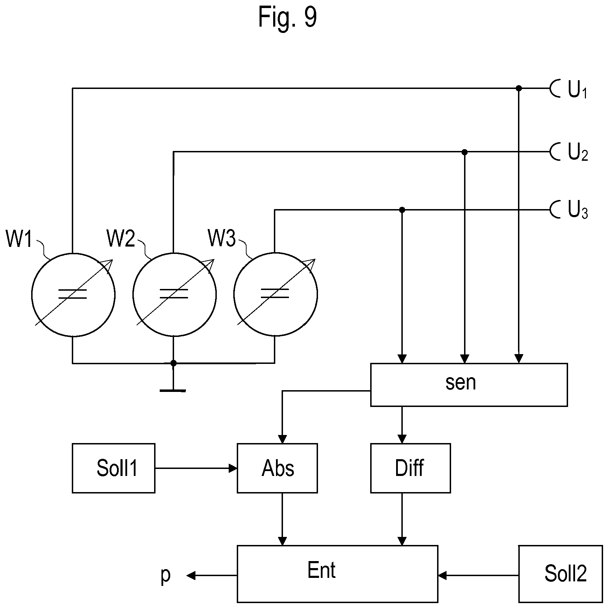

Fig. 9 zeigt einen Aufbau mit drei Wandlereinheiten W1, W2, W3. An den Ausgängen liegen drei Spannungen U₁, U₂, U₃ an, welche mit einer Sensoreinheit sen erfasst werden. Eine erste Auswertelogik Abs wertet eine Veränderung der absoluten Spannungswerte aus, wohingegen eine zweite Auswertelogik Diff Veränderungen der Differenzen dieser Spannungswerte auswertet. Die erste Auswertelogik Abs überwacht insbesondere während eines Hochlaufs der Stromversorgung die Spannungen an den Ausgängen. Der ersten Auswertelogik Abs sind Sollwerte Soll1 als Grenzwerte zugeführt, ab welchen die Entscheidung getroffen wird, ob eine Parallelschaltung vorliegt oder nicht. Eine vorgebbare Mindestspannung verhindert, dass infolge von Auswertetoleranzen die Erkennung eines Gleichlaufes von zwei oder mehreren Wandlereinheiten bei zu geringen Absolutwerten nicht eindeutig ist und eine fehlerhafte Schlussfolgerung gezogen wird.

Die Ergebnisse der beiden Auswertelogiken Abs, Diff werden einer Entscheidungslogik Ent zugeführt, welche anhand der oben erläuterten Kriterien entscheidet, ob eine Parallelschaltung vorliegt. Dabei werden Sollwerte Soll2 mit Grenzwerten für eine maximale Toleranz von Differenzspannungen empfangen. Im Falle einer Parallelschaltung erfolgt die Ausgabe eines Ergebnissignals p.

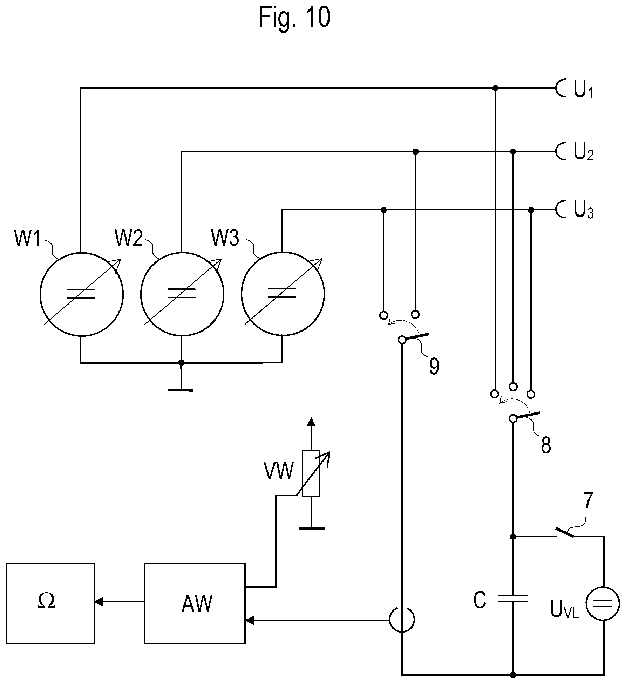

Eine Schaltungsanordnung zum Erkennen einer Parallelschaltung im Betrieb durch Einprägen eines Stromes ist in Fig. 10 dargestellt. Die Stromversorgung umfasst wieder drei Wandlereinheiten W1, W2, W3. Ein Kondensator C wird über einen Schalter 7 auf die Spannung einer Hilfsversorgung U_{VL} aufgeladen. Dann erfolgt hintereinander mittels zweier mehrpoliger Schalter 8, 9 bzw. einer aufeinander abgestimmten Schalteranordnung eine sequenzielle Anschaltung der Kondensatorspannung an jeweils zwei Ausgänge, wobei zwischendurch immer wieder eine Aufladung des Kondensators C vorgenommen wird.

Während einer Beaufschlagung zweier Ausgänge mit der Kondensatorspannung wird ein Entladestrom des Kondensators C erfasst und einer Auswerteeinheit AW zugeführt. Diese Auswerteeinheit AW vergleicht den erfassten Entladestrom mit einem Vorgabewert VW und gibt ein Meldesignal Ω aus, welches anzeigt, ob eine Verbindung zwischen zwei Ausgängen niederohmig oder hochohmig ist. Eine Parallelschaltung wird bei niederohmiger Verbindung angenommen. Der Vorgabewert VW wird dabei vorteilhafterweise so eingestellt, dass unter Berücksichtigung der Innenwiderstände der Ausgangskondensatoren der einzelnen Wandlereinheiten ein minimaler Strom für eine minimale Zeit aus dem Kondensator C fließen muss, ehe im Fall einer nicht erfolgten Parallelschaltung eine Spannungsänderung an den Ausgängen messbar ist.

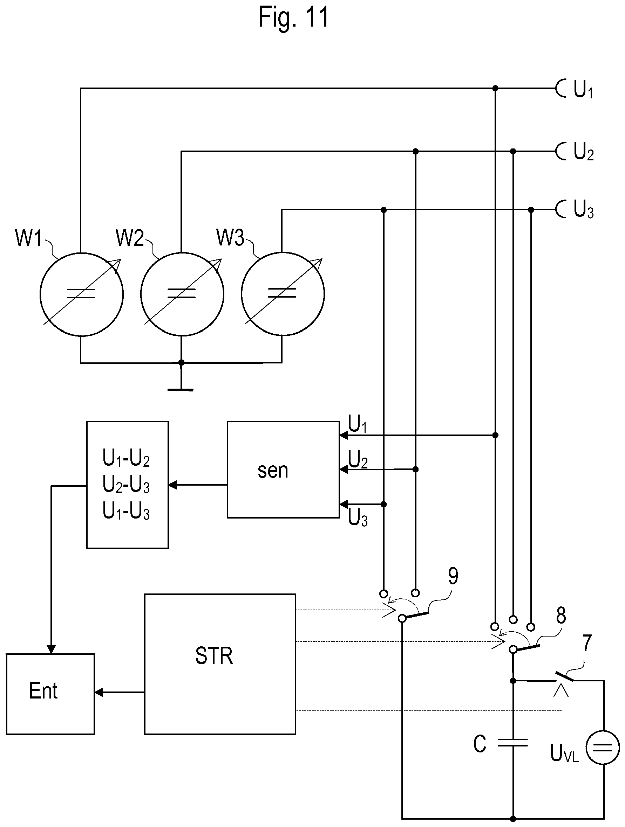

Eine vereinfachte Methode ist anwendbar, wenn die Ausgänge der Wandereinheiten W1, W2, W3 keine niederohmigen Ausgangskondensatoren aufweisen (Fig. 11). Wie zu Fig. 10 erläutert, wird an jeweils zwei Ausgänge in sequenzieller Abfolge eine Kondensatorspannung angelegt. Die Schalter 7, 8, 9 werden dabei mittels einer übergeordneten Steuerung STR angesteuert.

Während dieses Vorgangs werden den Spannungen U₁, U₂, U₃ an den Ausgängen der Wandereinheiten W1, W2, W3 erfasst und über eine Sensoreinheit sen und einer Differenzbildung U₁- U₂, U₂-U₃, U₁- U₃ einer Auswertelogik Diff zugeführt. Bei der Differenzbildung U₁- U₂, U₂- U₃, U₁- U₃ werden alle Spannungsdifferenzen zwischen den einzelnen Ausgängen ermittelt. Eine nachfolgende Entscheidungslogik Ent wertet aus, ob zwischen zwei Ausgängen eine Parallelschaltung vorliegt. Zu diesem Zweck erhält die Entscheidungslogik Ent synchrone Schaltdaten der Schalter 8,9 von der übergeordneten Steuerung STR, um die ausgewerteten Spannungen U₁, U₂, U₃ den einzelnen Ausgängen zuordnen zu können.

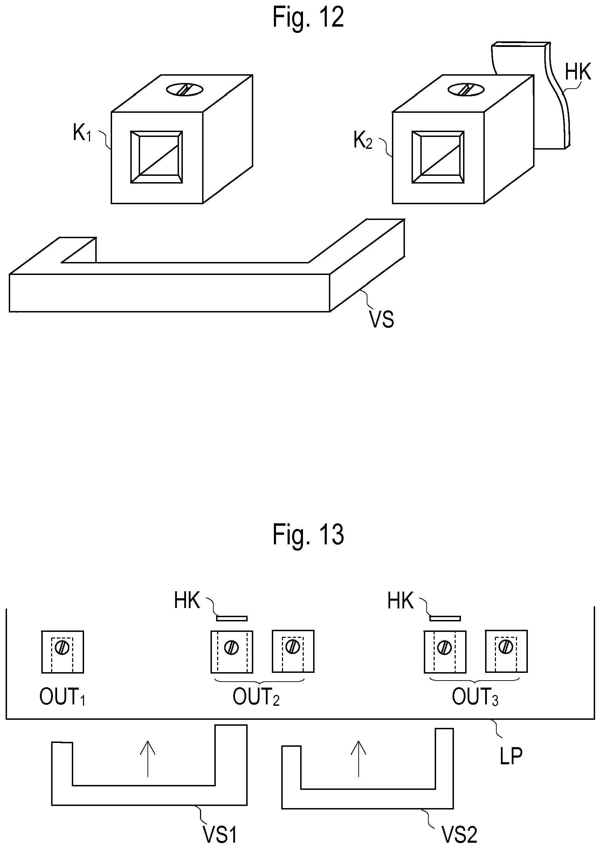

Fig. 12 zeigt eine Anordnung mit einem Verbindungsstück VS, das zwei Ausgangsklemmen K₁, K₂ verbindet. Das Verbindungsstück VS ist günstigerweise aus Kupfer gefertigt und weist in diesem Bespiel eine Bügelform auf. Hinter der zweiten Ausgangsklemme K2 ist ein Hilfskontakt HK angeordnet. Im eingesteckten Zustand ist das Verbindungsstück VS mit diesem Hilfskontakt HK elektrisch leitend verbunden, wodurch ein am Hilfskontakt HK anliegendes Erkennungssignal seinen Signalzustand ändert. Konkret erfolgt eine Potenzialweiterleitung der Leistungsverbindung auf den Hilfskontakt HK.

In Fig. 13 ist eine Leiterplatte LP mit drei Wandlerausgänge OUT₁, OUT₂, OUT₃ dargestellt. Der erste Wandlerausgang OUT1 weist eine Ausgangsklemme auf, wohingegen die beiden andern Ausgänge OUT₂, OUT₃ jeweils zwei Ausgangsklemmen aufweisen. Zur Verbindung der Ausgänge OUT₁, OUT₂ bzw. OUT₂, OUT₃ sind unterschiedlich ausgeformte Verbindungsstücke VS1, VS2 vorgesehen, sodass immer nur genau definierte Ausgänge OUT₁, OUT₂ bzw. OUT₂, OUT₃ miteinander verschaltbar sind.

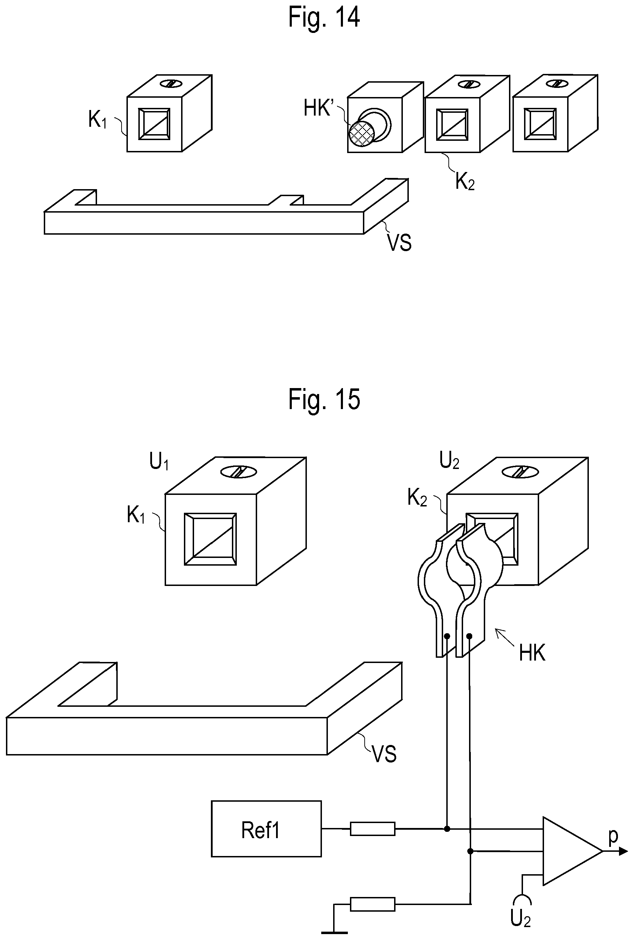

Fig. 14 zeigt eine Klemmenanordnung mit einem Betätigungselement HK'. Der Hilfskontakt zur Änderung des Erkennungssignals wird mit diesem Betätigungselement HK' beeinflusst. Sobald zwei Klemmen K₁, K₂ mittels eines Verbindungsstücks VS verbunden werden, betätigt dieses Verbindungsstück VS automatisch das Betätigungselement, wodurch eine Parallelschaltung signalisiert wird.

Alternativ kann das Betätigungselement HK' als magnetisch sensitiver Schalter ausgeführt sein (beispielsweise ein Reed-Relais). Dabei wird im Verbindungsstück VS ein Magnet an der Stelle angeordnet, der im Fall einer Parallelschaltung der Ausgänge mittels Verbindungsstück VS den magnetischen Sensor aktiviert. Bei der Anordnung von zwei oder mehr Sensoren können unterschiedliche Ausführungen der Verbindungsstücke VS erkannt werden. Dies ist etwa von Vorteil, wenn ein modifiziertes Verbindungsstück VS mehr als zwei Ausgänge verbindet, die nicht direkt nebeneinander platziert sind. Eine solche Mehrfachverbindung erfordert eine andere Master-Slave-Zuordnung der Steuerungen als eine Verbindung zweier Ausgänge mittels eines einfachen Verbindungsstücks VS.

Eine Variante, um eine Parallelschaltung noch vor der Kontaktierung der Leistungsausgänge zu erfassen, ist in Fig. 15 dargestellt. Zwei Klemmen K₁, K₂ sind wieder mittels eines Verbindungsstücks VS verbindbar. Ein Hilfskontakt HK ist vor einer Aufnahmeöffnung der zweiten Klammer K₂ angeordnet. Zudem besteht der Hilfskontakt HK aus zwei Einzelkontakten, die mittels Verbindungsstück VS kurz geschossen werden.

Ein Einzelkontakt wird auf eine Referenzspannung Refl gelegt. Der andere Einzelkontakt liegt über einen Pull-down an einer Masse. Eine Verbindung der beiden Einzelkontakte mittels Verbindungsstück VS ist über einen Komparator feststellbar. Wird das Verbindungsstück VS in die Klemme K₂ geschoben, sodass auch eine Verbindung mit der zweiten Ausgangsspannung U₂ vorliegt, weisen beide Einzelkontakte das Potenzial dieser Ausgangsspannung U₂ auf. In einem Komparator, dem die zweite Ausgangsspannung U₂ ebenfalls zugeführt ist, wird auch diese Änderung erfasst, wodurch sichergestellt ist, dass das richtige Verbindungsstück VS in die Klemme K₂ gesteckt wurde.

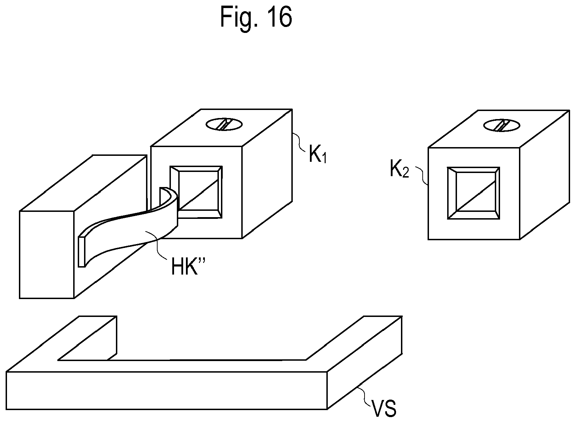

Fig. 16 zeigt eine Anordnung mit einem Mikroschalter HK", der vor einer Klemme K₁ angeordnet ist. Das Plazieren dieses Mikroschalters HK" erfolgt in der Weise, dass beim Einstecken eines vorgesehen Verbindungsstücks VS ein Kontakt zwischen Verbindungsstück VS und Mikroschalter HK" unvermeidbar ist.

Zur Parallelschaltung sind auch bekannte Doppelklemmen einsetzbar, wenn diese entsprechend modifiziert werden. Solche Doppelklemmen sind in einem gemeinsamen Gehäuse angeordnet. In dem Gehäuse erstreckt sich über die Breite beider Klemmen ein Schlitz, in den gefederte Anschlüsse beider Klemmen hineinragen. Verbunden werden die Klemmenkontakte, indem in den Schlitz ein Verbindungsblättchen eingeschoben wird. Für die vorliegende Erfindung ist in dem Schlitz zusätzlich ein Hilfskontakt zur Beeinflussung eines Erkennungssignals vorzusehen.

Alle Ausführungen, die in Bezug auf zwei, drei oder vier Wandlereinheiten beschrieben sind, gelten in gleicher Weise für mehr Wandlereinheiten. Die Überprüfungsanordnungen sind dann entsprechend zu erweitern und die Überprüfungsverfahren sind sequenziell für alle möglichen Parallelverbindungen der einzelnen Ausgänge durchzuführen.

## Patentansprüche

1. Stromversorgung mit wenigstens einer ersten und einer zweiten Wandlereinheit (W1, W2), wobei die erste Wandlereinheit (W1) mit einer ersten Steuerung (S1) angesteuert ist und an einem ersten Ausgang (OUT1) eine mittels einem ersten Spannungsregler geregelte erste Ausgangsspannung (U1) und/oder einen mittels eines ersten Stromreglers geregelten Ausgangsstrom liefert, wobei die zweite Wandlereinheit (W2) mit einer zweiten Steuerung (S2) angesteuert ist und an einem zweiten Ausgang (OUT2) eine mittels einem zweiten Spannungsregler regelbare zweite Ausgangsspannung (U2) und/oder einen mittels eines zweiten Stromreglers regelbaren Ausgangsstrom liefert und wobei die beiden Ausgänge (OUT1, OUT2) zur Bereitstellung einer höhere Ausgangsleistung parallelschaltbar sind, wobei bei erkannter Parallelschaltung beide Spannungsregler und/oder Stromregler durch Vorgabe aufeinander abgestimmter Spannungssollwerte (USoll1, USoll2) bzw. Stromsollwerte (ISoll1, ISoll2) gekoppelt sind, **dadurch gekennzeichnet, dass** eine übergeordnete Steuerung (STR) eine Überwachungseinheit zum Erkennen einer ausgangsseitigen Parallelschaltung umfasst, dass der Überwachungseinheit ein Erkennungssignal zugeführt ist, welches bei parallel geschalteten Ausgängen automatisch seinen Signalzustand ändert und dass die übergeordnete Steuerung (STR) mit den Steuerungen (S1, S2) der beiden Wandlereinheiten (W1, W2) zur Änderung der Sollwerte (USoll1, USoll2, ISoll1, ISoll2) verbunden ist.

2. Stromversorgung nach Anspruch 1, **dadurch gekennzeichnet, dass** die Spannungssollwerte (USoll1, USoll2) als ein gemeinsamer Spannungssollwert (USoll1) vorgegeben sind.

3. Stromversorgung nach Anspruch 1, **dadurch gekennzeichnet, dass** die Stromsollwerte (ISoll1, ISoll2) als ein gemeinsamer Stromsollwert (ISoll1) vorgegeben sind.

4. Stromversorgung nach einem der Ansprüche 1 bis 3, **dadurch gekennzeichnet, dass** jede Steuerung (S1 bzw. S2) einen Stromregler zur Regelung eines über den zugeordneten Ausgang (OUT1 bzw. OUT2) fließenden Stromes umfasst.

5. Stromversorgung nach Anspruch 4, **dadurch gekennzeichnet, dass** jeder Stromregler den gekoppelten Spannungsreglern unterlagert ist.

6. Stromversorgung nach einem der Ansprüche 1 bis 4, **dadurch gekennzeichnet, dass** eine Steuerung (S1 bzw. S2) als Master eingerichtet ist und dass bei Erkennen einer Parallelschaltung die andere Steuerung (S2 bzw. S1) als Slave die Sollwerte (USoll1, ISoll1 bzw. USoll2, ISoll2) des Masters (S1 bzw. S2) übernimmt.

7. Stromversorgung nach einem der Ansprüche 1 bis 6, **dadurch gekennzeichnet, dass** die beiden Ausgänge (OUT1, OUT2) mittels eines Verbindungsstücks (VS) verbunden sind und dass das Verbindungsstück (VS) mechanisch an einen elektrischen Hilfskontakts (HK) zur Beeinflussung des Erkennungssignals gekoppelt ist.

8. Stromversorgung nach Anspruch 7, **dadurch gekennzeichnet, dass** bei mehr als zwei Ausgängen (OUT1, OUT2, OUT3) die Abmessungen des Verbindungsstücks (VS) und der Ausgänge (OUT1, OUT2, OUT3) in der Weise vorgegeben sind, dass nur bestimmte Ausgänge (OUT1, OUT2 bzw. OUT2, OUT3) mittels Verbindungsstück (VS) verbindbar sind.

9. Stromversorgung nach Anspruch 7 oder 8, **dadurch gekennzeichnet, dass** bei nicht verbundenen Ausgängen (OUT1, OUT2) der elektrische Hilfskontakt (HK) offen oder geschlossen ist und dass bei verbundenen Ausgängen (OUT1, OUT2) mittels Verbindungsstück (VS) dieser elektrische Hilfskontakt (HK) geschlossen oder geöffnet ist.

10. Stromversorgung nach Anspruch 7 oder 8, **dadurch gekennzeichnet, dass** bei verbundenen Ausgängen (OUT1, OUT2) mittels Verbindungsstück (VS) ein elektromechanisches Betätigungselement (HK') betätigt ist.

11. Stromversorgung nach Anspruch 7 oder 8, **dadurch gekennzeichnet, dass** bei verbundenen Ausgängen (OUT1, OUT2) mittels Verbindungsstück (VS) ein mechanischer oder elektromagnetischer Sensor aktiviert ist.

12. Verfahren zum Betreiben einer Stromversorgung mit wenigstens einer ersten und einer zweiten Wandlereinheit (W1, W2), wobei die erste Wandlereinheit (W1) mittels einer ersten Steuerung (S1) angesteuert wird zur Ausgabe einer mittels eines ersten Spannungsreglers geregelten Ausgangsspannung (U1) und/der eines mittels eines ersten Stromreglers geregelten ersten Ausgangsstromes an einem ersten Ausgang (OUT1), wobei die zweite Wandlereinheit (W2) mittels einer zweiten Steuerung (S2) angesteuert wird zur Ausgabe einer mittels eines zweiten Spannungsreglers geregelten zweiten Ausgangsspannung (U2) und/der eines mittels eines zweiten Stromreglers geregelten zweiten Ausgangsstromes an einem zweiten Ausgang (OUT2) und wobei die beiden Ausgänge (OUT1, OUT2) zur Bereitstellung einer höhere Ausgangsleistung parallel geschaltet werden, wobei bei erkannter Parallelschaltung beiden Spannungsreglern und/oder Stromreglern aufeinander abgestimmte Spannungssollwerte (USoll1, USoll2) bzw. Stromsollwerte (ISoll1, ISoll2) vorgegeben werden, **dadurch gekennzeichnet, dass** eine übergeordnete Steuerung (STR), welche mit den Steuerungen (S1, S2) der beiden Wandlereinheiten (W1, W2) zur Änderung der Sollwerte (USoll1, USoll2, ISoll1, ISoll2) verbunden ist, eine Überwachungseinheit zum Erkennen einer ausgangsseitigen Parallelschaltung umfasst, dass der Überwachungseinheit ein Erkennungssignal zugeführt wird, welches bei parallel geschalteten Ausgängen automatisch seinen Signalzustand ändert.

13. Verfahren nach Anspruch 12, **dadurch gekennzeichnet, dass** bei einer Verbindung der beiden Ausgänge (OUT1, OUT2) mittels eines Verbindungsstücks (VS) zusätzlich mittels Verbindungsstück (VS) ein Hilfskontakt (HK) geöffnet oder geschlossen wird.

14. Verfahren nach Anspruch 12, **dadurch gekennzeichnet, dass** bei einem Hochlaufvorgang der Stromversorgung eine Parallelschaltung der Ausgänge (OUT1, OUT2) geprüft wird, indem zuerst die erste Wandlereinheit (W1) hochgefahren wird und dass dabei am Ausgang (OUT2) der zweiten Wandlereinheit (W2) die Ausgangsspannung (U2) als Erkennungssignal erfasst wird.

15. Verfahren nach Anspruch 12, **dadurch gekennzeichnet, dass** jede Wandlereinheit (W1, W2) mittels eines Stromreglers angesteuert wird, dass im laufenden Betrieb einem Stromregler ein kurzzeitig veränderter Stromsollwert (I'Soll2) vorgegeben wird und dass währenddessen die Differenz der beiden Ausgangsspannungen (U1, U2) als Erkennungssignal erfasst wird.

16. Verfahren nach Anspruch 12, **dadurch gekennzeichnet, dass** jede Wandlereinheit (W1, W2) mittels eines Stromreglers angesteuert wird, dass im laufenden Betrieb eine Wandlereinheit (W2) mit kurzzeitig verändertem Stromsollwert (I'Soll2) angesteuert wird und dass währenddessen ein Stromistwert der anderen Wandlereinheit (W1) als Erkennungssignal erfasst wird.

17. Verfahren nach Anspruch 12, **dadurch gekennzeichnet, dass** zwischen den beiden Ausgängen (OUT1, OUT2) mittels einer zusätzlichen Spannungsquelle (UVL) Strom eingeprägt wird und dass dabei die Differenz der beiden Ausgangsspannungen (U1, U2) als Erkennungssignal erfasst wird.

18. Verfahren nach Anspruch 12, **dadurch gekennzeichnet, dass** jeder Wandlereinheit (W1, W2) mittels eines Stromreglers angesteuert wird, dass einer Wandlereinheit (W2) kurzzeitig ein Stromsollwert (I'Soll2) direkt vorgegeben wird, sodass die entsprechende Wandlereinheit (W2) im reinen Stromquellbetrieb läuft und dass die Spannung (U2) am Ausgang (OUT2) dieser Wandlereinheit (W2) als Erkennungssignal erfasst wird.

19. Verfahren nach Anspruch 18, **dadurch gekennzeichnet, dass** der direkt vorgegebene Stromsollwert (I'Soll2) dem Stromsollwert (ISoll1) der anderen Wandlereinheit (W1) entspricht.

20. Verfahren nach einem der Ansprüche 15 bis 19, **dadurch gekennzeichnet, dass** die Differenz der beiden Ausgangsspannungen (U1, U2) laufend erfasst wird und dass bei einem Abfall dieser Differenz unter einen Mindestwert ein Erkennungsvorgang für eine mögliche Parallelschaltung der beiden Ausgänge (OUT1, OUT2) eingeleitet wird.

21. Verfahren nach einem der Ansprüche 12 bis 20, **dadurch gekennzeichnet, dass** bei beiden Wandlereinheiten (W1, W2) eine interne Ausgangsspannung erfasst wird, dass bei erkannter Parallelschaltung die Differenz dieser internen Ausgangsspannungen mit einem vorgegebenen Maximalwert verglichen wird und dass bei Überschreitung des Maximalwertes eine Abschaltung der Stromversorgung oder eine Aktivierung eines Meldesignals erfolgt.

## Claims

1. Power supply unit comprising at least one first and one second converter unit (W1, W2), wherein the first converter unit (W1) is controlled with a first controller (S1) and supplies a first output voltage (U1) regulated by means of a first voltage regulator and/or an output current regulated by means of a first current regulator at a first output (OUT1), wherein the second converter unit (W2) is controlled by a second controller (S2) and supplies a second output voltage (U2) able to be regulated by means of the second voltage regulator and/or an output current able to be regulated by means of a second current regulator at a second output (OUT2) and wherein the two outputs (OUT1, OUT2) are able to be connected in parallel for providing a higher output power, wherein for a recognised parallel connection the two voltage converters and/or current converters are coupled by predetermining desired voltage values (USoll1, USoll2) or current values (ISoll1, ISoll2) matched to one another, **characterised in that** a higher-ranking controller (STR) comprises a supervision unit for recognising an output-side parallel connection, that the supervision unit is supplied with a recognition signal, which for parallel-switched outputs automatically changes its signal state and that the higher-ranking controller (STR) is connected to the controllers (S1, S2) of the two converter units (W1, W2) for changing the desired values (USoll1, USoll2, ISoll1, ISoll2).

2. Power supply unit according to claim 1, **characterised in that** the desired voltage values (USoll1, USoll2) are predetermined as a common desired voltage value (USoll1).

3. Power supply unit according to claim 1, **characterised in that** the desired current values (ISoll1. ISoll2) are predetermined as a common desired current value (ISoll1).

4. Power supply unit according to one of claims 1 to 3, **characterised in that** each controller (S1 or S2) includes a current converter for regulating a current flowing via the assigned output (OUT1 or OUT2).

5. Power supply unit according to claim 4, **characterised in that** each current regulator is subordinate to the coupled voltage regulators.

6. Power supply unit according to one of claims 1 to 4, **characterised in that** one controller (S1 or S2) is configured as master and that, on recognition of a parallel connection, the other controller (S2 or S1) as slave takes over the desired values (USoll1, ISoll1 or USoll2, ISoll2) of the master (S1 or S2).

7. Power supply unit according to one of claims 1 to 6, **characterised in that** the two outputs (OUT1, OUT2) are connected by means of a connecting piece (VS) and that the connecting piece (VS) is coupled mechanically to an electric auxiliary contact (HK) for influencing the recognition signal.

8. Power supply unit according to claim 7, **characterised in that,** for more than two outputs (OUT1, OUT2, OUT3) the dimensions of the connecting piece (VS) and of the outputs (OUT1, OUT2, OUT3) are predetermined so that only specific outputs (OUT1, OUT2 or OUT2, OUT3) are able to be connected by means of connecting piece (VS).

9. Power supply unit according to claim 7 or 8, **characterised in that,** when the outputs (OUT1, OUT2) are not connected, the electric auxiliary contact (HK) is open or closed and, when the outputs (OUT1, OUT2) are connected by means of the connecting piece (VS), this electric auxiliary contact (HK) is closed or opened.

10. Power supply unit according to claim 7 or 8, **characterised in that,** when the outputs (OUT1, OUT2) are connected by means of the connecting piece (VS), an electromechanical actuation element (HK') is actuated.

11. Power supply unit according to claim 7 or 8, **characterised in that,** when the outputs (OUT1, OUT2) are connected by means of the connecting piece (VS), a mechanical or electromagnetic sensor is activated.

12. Method for operating a power supply unit comprising at least one first and one second converter unit (W1, W2), wherein the first converter unit (W1) is controlled with a first controller (S1) to output a first output voltage (U1) regulated by means of a first voltage regulator and/or a first output current regulated by means of a first current regulator at a first output (OUT1), wherein the second converter unit (W2) is controlled by a second controller (S2) to output a second output voltage (U2) regulated by means of a second voltage regulator and/or a second output current regulated by means of a second current regulator at a second output (OUT2) and wherein the two outputs (OUT1, OUT2) are connected in parallel to provide a higher output power, wherein for a recognised parallel connection, the two voltage converters and/or current converters are predefined desired voltage values (USoll1, USoll2) or current values (ISoll1, ISoll2) that are matched to one another, **characterised in that** a higher-ranking controller (STR), which is connected to the controllers (S1, S2) of the two converter units (W1, W2) for changing the desired values (USoll1, USoll2, ISoll1, ISoll2), comprises a supervision unit for recognising an output-side parallel connection, that the supervision unit is supplied with a recognition signal, which for parallel-switched outputs automatically changes its signal state.

13. Method according to claim 12, **characterised in that,** when the two outputs (OUT1, OUT2) are connected by means of a connecting piece (VS), an auxiliary contact (HK) is additionally opened or closed by means of connecting piece (VS) .

14. Method according to claim 12, **characterised in that,** during a startup process of the power supply unit, a parallel connection of the outputs (OUT1, OUT2) is checked, **in that** the first converter unit (W1) is started up first and that during this process the output voltage (U2) is detected as recognition signal at the output (OUT2) of the second converter unit (W2).

15. Method according to claim 12, **characterised in that** each converter unit (W1, W2) is controlled by means of a current regulator, that in ongoing operation a briefly changed desired voltage value (I'Soll2) is predetermined to a current converter and during this process the difference between the two output voltages (U1, U2) is detected as the recognition signal.

16. Method according to 12, **characterised in that** each converter unit (W1, W2) is controlled by means of a current regulator, that in ongoing operation a briefly changed desired current value (I'Soll2) is predetermined to a current converter (W2) and during this process an actual current value of the other converter unit (W1) is detected as the recognition signal.

17. Method according to claim 12, **characterised in that** current is injected between the two outputs (OUT1, OUT2) by means of additional voltage source (UVL) and that during this process the difference between the two output voltages (U1, U2) is detected as the recognition signal.

18. Method according to claim 12, **characterised in that** each converter unit (W1, W2) is controlled by means of a current regulator, that a desired current value (I'Soll2) is briefly specified directly to one converter unit (W2) so that the corresponding converter unit (W2) runs in pure current source mode and that the voltage (U2) at the output (OUT2) of this converter unit (W2) is detected as the recognition signal.

19. Method according to claim 18, **characterised in that** the directly predetermined desired current value (I'Soll2) corresponds to the desired current value (ISoll2) of the other converter unit (W1).

20. Method according to claim one of claims 15 to 19, **characterised in that** the difference between the two output voltages (U1, U2) is detected continuously and that, if this difference falls below a minimum value, a recognition process for a possible parallel connection of the two outputs (OUT1, OUT2) is initiated.

21. Method according to one of claims 12 to 20, **characterised in that** an internal output voltage is detected for both converter units (W1, W2), that if a parallel connection is recognised, the difference between these internal output voltages is compared with a predetermined maximum value and that, if the maximum value is exceeded, there is a switch-off of the power supply unit or an activation of a notification signal.

## Revendications

1. Alimentation électrique avec au moins une première et une deuxième unités de conversion (W1, W2), la première unité de conversion (W1) étant contrôlé avec une première commande (S1) et délivrant, au niveau d'une première sortie (OUT1), une première tension de sortie (U1) régulée au moyen d'un premier régulateur de tension et/ou un courant de sortie régulé au moyen d'un premier régulateur de courant, la deuxième unité de conversion (W2) étant contrôlée avec une deuxième commande (S2) et délivrant, au niveau d'une deuxième sortie (OUT2), une deuxième tension de sortie (U2) pouvant être régulée au moyen d'un deuxième régulateur de tension et/ou un courant de sortie pouvant être régulé au moyen d'un deuxième régulateur de courant et les deux sorties (OUT1, OUT2) pouvant être branchées en parallèle pour la mise à disposition d'une puissance de sortie supérieure, moyennant quoi, lorsque le branchement en parallèle est détecté, les deux régulateurs de tension et/ou régulateurs de courant sont couplés par la spécification de valeurs de consigne de tension (USoll1, USoll2) resp. de valeurs de consigne de courant (ISoll1, ISoll2) harmonisées entre elles, **caractérisée en ce qu'**une commande de niveau supérieur (STR) comprend une unité de surveillance pour la détection d'un branchement en parallèle côté sortie, **en ce que**, dans l'unité de surveillance, est introduit un signal de détection qui, dans le cas de sorties branchées en parallèle, modifie automatiquement son état de signal et **en ce que** la commande de niveau supérieur (STR) est reliée avec les commandes (S1, S2) des deux unités de conversion (W1, W2) pour la modification des valeurs de consigne (USoll1, USoll2, ISoll1, ISoll2).

2. Alimentation électrique selon la revendication 1, **caractérisée en ce que** les valeurs de consigne de tension (USoll1, USoll2) sont prédéterminées sous la forme d'une valeur de consigne de tension (USoll1) commune.

3. Alimentation électrique selon la revendication 1, **caractérisée en ce que** les valeurs de consigne de courant (ISoll1, ISoll2) sont prédéterminées sous la forme d'une valeur de consigne de courant (ISoll1) commune.

4. Alimentation électrique selon l'une des revendications 1 à 3, **caractérisée en ce que** chaque commande (S1 resp. S2) comprend un régulateur de courant pour la régulation d'un courant s'écoulant par l'intermédiaire de la sortie (OUT1 resp. OUT2) correspondante.

5. Alimentation électrique selon la revendication 4, **caractérisée en ce que** chaque régulateur de courant est asservi aux régulateurs de tension couplés.

6. Alimentation électrique selon l'une des revendications 1 à 4, **caractérisée en ce qu'**une commande (S1 resp. S2) est conçue comme un maître et **en ce que**, lors de la détection d'un branchement en parallèle, l'autre commande (S2 resp. S1) prend en compte, en tant qu'esclave, les valeurs de consigne (USoll1, ISoll1 resp. USoll2, ISoll2) du maître (S1 resp. S2).

7. Alimentation électrique selon l'une des revendications 1 à 6, **caractérisée en ce que** les deux sorties (OUT1, OUT2) sont reliées au moyen d'un élément de liaison (VS) et **en ce que** l'élément de liaison (VS) est couplé mécaniquement à un contact électrique auxiliaire (HK) pour le contrôle du signal de détection.

8. Alimentation électrique selon la revendication 7, **caractérisée en ce que**, dans le cas de plus de deux sorties (OUT1, OUT2, OUT3), les dimensions de l'élément de liaison (VS) et des sorties (OUT1, OUT2, OUT3) sont prédéterminées de façon à ce que seules des sorties déterminées (OUT1, OUT2 resp. OUT2, OUT3) puissent être reliées au moyen de l'élément de liaison (VS) .

9. Alimentation électrique selon la revendication 7 ou 8, **caractérisée en ce que**, lorsque les sorties (OUT1, OUT2) ne sont pas reliées, le contact électrique auxiliaire (HK) est ouvert ou fermé et **en ce que**, lorsque les sorties (OUT1, OUT2) sont reliées au moyen de l'élément de liaison (VS), ce contact électrique auxiliaire (HK) est fermé ou ouvert.

10. Alimentation électrique selon la revendication 7 ou 8, **caractérisée en ce que**, lorsque les sorties (OUT1, OUT2) sont reliées au moyen de l'élément de liaison (VS), un élément d'actionnement électromécanique (HK') est actionné.

11. Alimentation électrique selon la revendication 7 ou 8, **caractérisée en ce que**, lorsque les sorties (OUT1, OUT2) sont reliées au moyen de l'élément de liaison (VS), un capteur mécanique ou électromagnétique est activé.

12. Procédé de commande d'une alimentation électrique avec au moins une première et une deuxième unités de conversion (W1, W2), la première unité de conversion (W1) étant contrôlé au moyen d'une première commande (S1) pour la sortie d'une première tension de sortie (U1) régulée au moyen d'un premier régulateur de tension et/ou d'un premier courant de sortie régulé au moyen d'un premier régulateur de courant, au niveau d'une première sortie (OUT1), la deuxième unité de conversion (W2) étant contrôlée au moyen d'une deuxième commande (S2) pour la sortie d'une deuxième tension de sortie (U2) régulée au moyen d'un deuxième régulateur de tension et/ou d'un deuxième courant de sortie régulé au moyen d'un deuxième régulateur de courant, au niveau d'une deuxième sortie (OUT2) et les deux sorties (OUT1, OUT2) pouvant être branchées en parallèle pour la mise à disposition d'une puissance de sortie supérieure, moyennant quoi, lorsque le branchement en parallèle des deux régulateurs de tension et/ou régulateurs de courant est détecté, des valeurs de consigne de tension (USoll1, USoll2) resp. de valeurs de consigne de courant (ISoll1, ISoll2), harmonisées entre elles, sont prédéterminées,
**caractérisé en ce qu'**une commande de niveau supérieur (STR), qui est reliée avec les commandes (S1, S2) des deux unités de conversion (W1, W2) pour la modification des valeurs de consigne (USoll1, USoll2, ISoll1, ISoll2), comprend une unité de surveillance pour la détection d'un branchement en parallèle côté sortie, **en ce que** dans l'unité de surveillance est introduit un signal de détection qui, lorsque les sorties sont branchées en parallèle, modifie automatiquement son état de signal.

13. Procédé selon la revendication 12, **caractérisé en ce que**, lorsque les deux sorties (OUT1, OUT2) sont reliées au moyen d'un élément de liaison (VS), un contact auxiliaire (HK) est en outre ouvert ou fermé au moyen de l'élément de liaison (VS) .

14. Procédé selon la revendication 12, **caractérisé en ce que**, lors d'une phase de démarrage de l'alimentation électrique, un branchement en parallèle des sorties (OUT1, OUT2) est vérifié en démarrant d'abord la première unité de conversion (W1) et **en ce que**, à la sortie (OUT2) de la deuxième unité de conversion (W2), la tension de sortie (U2) est alors prise en compte comme signal de détection.

15. Procédé selon la revendication 12, **caractérisé en ce que** chaque unité de conversion (W1, W2) est contrôlée au moyen d'un régulateur de courant, **en ce que**, lors du fonctionnement, une valeur de consigne de courant (I'Soll1) modifiée brièvement est spécifiée à un régulateur de courant et **en ce que**, pendant ce temps, la différence des deux tensions de sortie (U1, U2) est prise en compte comme signal de détection.

16. Procédé selon la revendication 12, **caractérisé en ce que** chaque unité de conversion (W1, W2) est contrôlée au moyen d'un régulateur de courant, **en ce que**, lors du fonctionnement, une unité de conversion (W2) est contrôlée avec une valeur de consigne de courant (I'Soll2) modifiée brièvement et ce que, pendant ce temps, une valeur effective de courant de l'autre unité de conversion (W1) est prise en compte comme signal de détection.

17. Procédé selon la revendication 12, **caractérisé en ce que**, entre les deux sorties (OUT1, OUT2), un courant est appliqué au moyen d'une source de tension supplémentaire (UVL) et **en ce que** la différence des deux tensions de sortie (U1, U2) est alors prise en compte comme signal de détection.

18. Procédé selon la revendication 12, **caractérisé en ce que** chaque unité de conversion (W1, W2) est contrôlée au moyen d'un régulateur de courant, **en ce que**, dans une unité de conversion (W2) est prédéterminée directement et brièvement une valeur de consigne de courant (I'Soll2), de façon à ce que l'unité de conversion (W2) correspondante fonctionnement purement en mode source de courant et **en ce que** la tension (U2) à la sortie (OUT2) de cette unité de conversion (W2) est prise en compte comme signal de détection.

19. Procédé selon la revendication 18, **caractérisé en ce que** la valeur de consigne de courant (I'Soll2) prédéterminée directement correspond à la valeur de consigne de courant (ISoll1) de l'autre unité de conversion (W1).

20. Procédé selon l'une des revendications 15 à 19, **caractérisé en ce que** la différence des deux tensions de sortie (U1, U2) est mesurée en continu et **en ce que**, lors d'une diminution de cette différence en dessous d'une valeur minimale, un processus de détection pour un branchement en parallèle possible des deux sorties (OUT1, OUT2) est initié.

21. Procédé selon l'une des revendications 12 à 20, **caractérisé en ce que**, dans les deux unités de conversion (W1, W2), est mesurée une tension de sortie interne, **en ce que**, lorsqu'un branchement en parallèle est détecté, la différence de ces tensions de sortie internes est comparée avec une valeur maximale prédéterminée et **en ce que**, lors d'un dépassement de la valeur maximale, a lieu un arrêt de l'alimentation électrique ou une activation d'un signal d'alarme.
